Europäisches Patentamt

European Patent Office

Office européen des brevets

(11) Veröffentlichungsnummer: **0 224 757 B1**

# EUROPÄISCHE PATENTSCHRIFT

(45) Veröffentlichungstag der Patentschrift: **15.07.92**

(21) Anmeldenummer: **86115567.9**

(22) Anmeldetag: **10.11.86**

(51) Int. Cl.⁵: **H01L 29/74**

(54) **Rückwärtsleitender Thyristor.**

(30) Priorität: **29.11.85 CH 5095/85**

(43) Veröffentlichungstag der Anmeldung:
**10.06.87 Patentblatt 87/24**

(45) Bekanntmachung des Hinweises auf die
Patenterteilung:
**15.07.92 Patentblatt 92/29**

(84) Benannte Vertragsstaaten:
**CH DE FR GB IT LI SE**

(56) Entgegenhaltungen:
**EP-A- 0 143 259**
**US-A- 4 037 245**

**BROWN BOVERI REVIEW, Band 66, Februar
1979, Seiten 5-10, Baden, CH; P. DE BRUYNE
et al.: "The reverse conducting thyristor and
its applications"**

(73) Patentinhaber: **BBC Brown Boveri AG
Haselstrasse
CH-5401 Baden(CH)**

(72) Erfinder: **Roggwiller, Peter, Dr.
Püntstrasse 16
CH-8173 Riedt-Neerach(CH)**

## Beschreibung

Die vorliegende Erfindung betrifft einen Rückwärtsleitenden Thyristor gemäss dem Oberbegriff des Anspruchs 1. Ein solcher Thyristor ist z.B. aus der Japanischen Patentanmeldung JP-A-58-40861 bekannt. Ein Rückwärtsleitender Thyristor allgemeiner Art ist darüberhinaus beispielsweise in der US-A-4,150,391 offenbart.

Unter Rückwärtsleitenden Thyristoren (RLT) werden integrierte Leistungshalbleiter verstanden, bei denen auf einem gemeinsamen Substrat eine Thyristorstruktur und eine Diodenstruktur so nebeneinander angeordnet sind, dass die Diode dem Thyristor antiparallel geschaltet ist.

Ein solcher Thyristor kann nur Blockierspannung aufnehmen, während er in Sperrichtung durch die antiparallele Diode kurzgeschlossen wird. Der damit verbundene Verzicht auf einen sperrenden p-n-Uebergang im Thyristor ermöglicht eine Reduzierung der Verluste in Durchlassrichtung bzw. eine Verringerung der Freiwerdezeit. Die daraus resultierenden Vorteile für die Anwendung werden z.B. in den Brown Boveri Mitteilungen, Band 66, Heft 1, 1979, Seiten 5-10, eingehend beschrieben.

Obgleich hinsichtlich der maximal möglichen Schaltfrequenz durch die Integration der antiparallelen Diode in einen Thyristor mit üblicher Struktur bereits Verbesserungen erreicht worden sind, ist es dennoch wünschenswert, bei zugleich hohen Leistungen mit noch höheren Frequenzen schalten zu können, wodurch der Anwendungsbereich des RLT erweitert würde.

Es ist nun weiterhin bekannt, dass den erwähnten üblichen Thyristoren hinsichtlich der Schaltfrequenz die sogenannten Feldgesteuerten Thyristoren (FCT = Field Controlled Thyristor) überlegen sind, wie sie beispielsweise in der Europäischen Patentanmeldung EP-A1-0 121 068 beschrieben worden sind.

So wird in der eingangs genannten Japanischen Patentanmeldung ein Rückwärtsleitender Feldgesteuerter Thyristor vom Statischen Induktionstyp (SITh) offenbart, der in das Substrat integrierte, antiparallele Dioden enthält. Die Integration eines Feldgesteuerten Thyristors und einer antiparallelen Diode auf einem gemeinsamen Substrat birgt jedoch folgendes Problem: Während beim herkömmlichen RLT die p-Basisschicht und die n-Basisschicht im Inneren des Substrats einen p-n-Uebergang bilden, der direkt für die antiparallele Diode verwendet werden kannn, ist bei einem FCT im Inneren des Substrats lediglich die n⁻-dotierte Kanalschicht vorhanden, die als Basis für die Diode herangezogen werden kann.

In der Japanischen Patentanmeldung wird die p-dotierte Gateschicht benutzt, um zusammen mit der Kanalschicht eine Diode zu bilden. Oberhalb der Gateschicht wird eine p⁺-dotierte Kontaktschicht vorgesehen, die einen ohmschen Kontakt zur Metallisierung vermittelt. Da der p-n-Uebergang der Diode in diesem Fall auf dem gleichen Niveau liegt, wie die Gateschicht im Thyristorteil, ist zur Entkopplung zwischen der Diode und dem Thyristor ein tiefer, geätzter und mit Isolationsmaterial gefüllter Graben notwendig, der zusätzliche Prozessschritte bei der Herstellung notwendig macht.

Aufgabe der vorliegenden Erfindung ist es nun, einen Rückwärtsleitenden FCT zu schaffen, der sich durch eine vereinfachte Entkopplung zwischen Thyristor- und Diodenteil auszeichnet.

Die Aufgabe wird bei einem Rückwärtsleitenden Thyristor der eingangs genannten Art durch die Merkmale aus dem Kennzeichen des Anspruchs 1 gelöst.

Die Erfindung soll nachfolgend anhand von Ausführungsbeispielen im Zusammenhang mit der Zeichnung näher erläutert werden. Es zeigen:

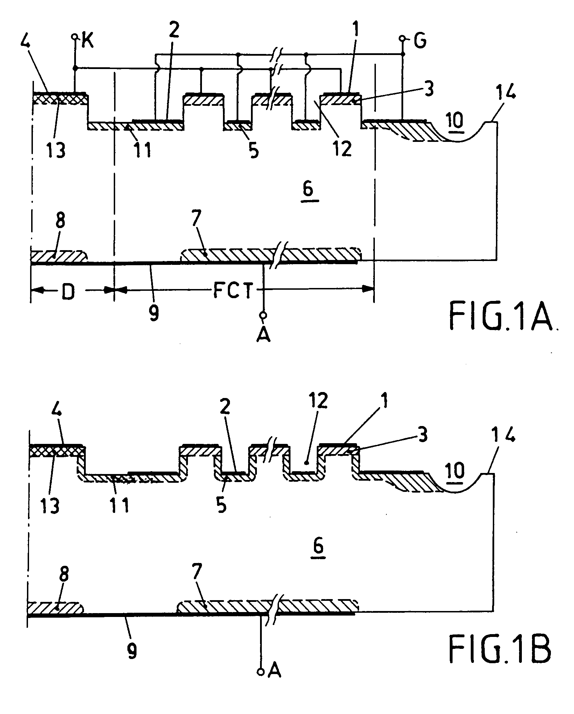

Fig. 1A  im Querschnitt den Aufbau eines RLT gemäss einem bevorzugten Ausführungsbeispiel der Erfindung mit innenliegendem Diodenteil und auf die Gräbenböden begrenzten Gatebereichen; und

Fig. 1B  die Konfiguration gemäss Fig. 1A mit auf die Grabenwände erweiterten Gatebereichen.

In Fig. 1A ist ausschnittweise in einem Querschnitt der strukturelle Aufbau eines RLT dargestellt, wie er sich für ein bevorzugtes Ausführungsbeispiel nach der Erfindung ergibt, wobei die Figur nur die rechte Hälfte des gesamten achsensymmetrischen Querschnitts wiedergibt. Die Gesamtstruktur ist aufgeteilt in einen aussenliegenden Feldgesteuerten Thyristor FCT und einen innenliegenden Diodenteil D. Beiden Teilelementen gemeinsam ist eine n⁻-dotierte Kanalschicht 6, die sich von Rand zu Rand quer durch das gesamte Bauelement erstreckt.

Die Anode A des Bauelements wird durch die Thyristoranode bestimmt. Entsprechendes gilt für die Kathode K und die Thyristorkathode. Da wegen der Antiparallelschaltung die Verhältnisse beim Diodenteil D genau umgekehrt sind, soll im Folgenden stets die jeweilige Elektrode des Bauelements und damit auch des Thyristors gemeint sein, wenn der Begriff "anodenseitig" bzw. "kathodenseitig" verwendet wird.

Der Diodenteil D weist drei übereinanderliegende Schichten auf, von denen die untere eine n⁺-Emitterschicht 8, die mittlere die bereits erwähnte n⁻-dotierte Kanalschicht 6 und die obere eine p⁺-dotierte Dioden-Anodenschicht 13 ist. Während die Kanalschicht 6 durch das ganze Bauelement verläuft, ist die laterale Ausdehnung der n⁺-Emitterschicht 8 sowie der Dioden-Anodenschicht 13 auf den Bereich des Diodenteils D beschränkt.

Der Feldgesteuerte Thyristor FCT in Fig. 1A entspricht prinzipiell dem aus der EP-A 0 121 068 bekannten. Er umfasst eine $p^+$-dotierte FCT-Anodenschicht 7, die darüberliegende $n^-$-dotierte Kanalschicht 6 und kathodenseitig eine fein unterteilte Gate-Kathodenstruktur, die sich aus abwechselnd angeordneten p-dotierten Gatebereichen 5 und $n^+$-dotierten Katodenbereichen 3 zusammensetzt. Für die Zuführung des Laststroms sind FCT-Anodenkontakte 1 und ein Anodenkontakt 9 vorgesehen, die üblicherweise als aufgedampfte Metallschichten ausgeführt sind.

Ebenso wie die $n^+$-Emitterschicht 8 in ihrer lateralen Ausdehnung auf den Bereich des in der Mitte des Bauelements angeordneten Diodenteil D begrenzt ist, erstreckt sich die FCT-Anodenschicht nur innerhalb des Bereichs des Feldgesteuerten Thyristors FCT.

Die einzelnen Kathodenbereiche 3 sind durch tiefe Gräben 12 voneinander getrennt. Die Gatekontakte 2 sind auf den Böden der Gräben 12 angeordnet. Die p-dotierten Gatebereiche 5 erstrecken sich im Ausführungsbeispiel der Fig. 1A ebenfalls über die Grabenböden.

Die Funktionsweise des Feldgesteuerten Thyristors FCT ist an sich bekannt. Durch Anlegen einer negativen Gatespannung zwischen Gate G und Kathode K entstehend am p-n-Uebergang zwischen den Gatebereichen 5 und der Kanalschicht 6 Verarmungsgebiete, die sich in das Kanalgebiet zwischen den Gatebereichen 5 ausdehnen und den zwischen FCT-Anodenschicht 7 und den Kathodenbereichen 3 fliessenden Strom einschnüren, bis er blockiert ist. An dem Thyristorelement fällt dann die ganze Anodenspannung ab. Das Verhältnis zwischen dieser Spannung und der Gatespannung wird als Blockierverstärkung bezeichnet und ist auf komplizierte Weise von den verschiedenen Dotierungen und geometrischen Abmessungen des Bauelements abhängig.

Während anodenseitig für den Diodenteil D und den Feldgesteuerten Thyristor FCT bevorzugt ein gemeinsamer Anodenkontakt 9 vorgesehen ist, der sowohl die $n^+$-Emitterschicht 8 als auch die FCT-Anodenschicht 7 weitgehend überdeckt, ist kathodenseitig zur elektrischen Entkopplung von Diode und Thyristor eine breite Gatezone 11 vorgesehen, der anodenseitig kein Bereich der $n^+$-Emitterschicht 8 gegenüberliegt. Die Breite der Gatezone 11 wird dabei bevorzugt mindestens so gross gewählt, wie die Dicke des Bauelements.

Die kathodenseitige Kontaktierung im Diodenteil D wird durch einen vorzugsweise aufgedampften Dioden-Anodenkontakt 9 erreicht, der in einer Ebene mit den FCT-Anodenkontakten 1 liegt und mit diesen durch einen von oben aufgesetzten tellerartigen Druckkontakt, der in Fig. 1A nicht dargestellt ist, leitend verbunden werden kann, wie dies in der Figur schematisch durch die eingezeichneten Leitungsverbindungen angedeutet ist.

Die Gatekontakte 2 ihrerseits, die alle in einer Gateebene 14 liegen, bilden eine zusammenhängende Kontaktschicht, so dass der elektrische Anschluss auf einfache Weise im frei zugänglichen Randbereich erfolgen kann. Diese Verhältnisse sind in der Fig. 1A ebenfalls durch die eingezeichneten Leitungsverbindungen nur schematisch angedeutet.

Ein weiteres bevorzugtes Ausführungsbeispiel für einen Rückwärtsleitenden Thyristor nach der Erfindung ist in Fig. 1B in einer zu der Fig. 1A analogen Weise dargestellt. Zur Vereinfachung sind hier die kathodenseitigen schematischen Verbinoungsleitungen weggelassen. Gleiches gilt für die Unterteilung in Diodenteil und Thyristorteil.

Der Unterschied zwischen den beiden in Fig. 1A und Fig. 1B dargestellten Strukturen besteht darin, dass in der letzteren die Gatebereiche 5 sich sowohl über die Grabenböden als auch über die seitlichen Grabenwände erstrecken. Hierdurch wird eine verbesserte Blockierverstärkung des Feldgesteuerten Thyristors FCT erreicht.

So erzielt man mit einer Thyristorstruktur gemäss Fig. 1B für eine Breite der Kathodenbereiche 3 von 30 $\mu$m, eine Dicke des Bauelements von 300 $\mu$m und eine $n^-$-Dotierungskonzentration in der Kanalschicht 6 von $3,5 \times 10^{13}$ cm$^{-3}$ (= 150 $\Omega \cdot$cm) bei einer Anodenspannung von 1600 V eine Blockierverstärkung von über 100. Dabei spielen die Grabentiefe einerseits, und die Tiefe des p-n-Uebergangs von Gatebereich 5 zu Kanalschicht 6 andererseits eine massgebende Rolle. Als besonders günstig haben sich eine Tiefe der Gräben 12 von 10 $\mu$m bis 30 $\mu$m, eine Breite der Kathodenbereiche 3 von 6 $\mu$m bis 40 $\mu$m und eine Dicke der Gatebereiche 5 von 5 $\mu$m bis 20 $\mu$m erwiesen. Die Randkonzentration der p-Dotierung in den Gatebereichen 5 sollte dabei $2 \times 10^{16}$ cm$^{-3}$ nicht überschreiten, damit der p-n-Uebergang zwischen Kathodenbereich 3 und Gatebereich 8 eine negative Gatespannung bis zu 50 V aufnehmen, d.h. sperren kann.

In allen beschriebenen Ausführungsbeispielen ist es auch von Vorteil, am Rande des Bauelements eine in den Figuren dargestellte Randkontur 10 vorzusehen, welche den Einfluss des Randes auf die elektrische Funktion des Bauelements begrenzen soll.

Insgesamt steht mit dem Rückwärtsleitenden Thyristor nach der Erfindung ein Bauelement für die Leistungselektronik zur Verfügung, welches sich durch vereinfachten Aufbau ebenso wie durch schnelles Schalten hoher Leistungen bei guten Ansteuerungseigenschaften auszeichnet.

**Patentansprüche**

**1.** Rückwärtsleitender Thyristor, umfassend

(a) ein scheibenförmiges Substrat mit einer Anodenseite und einer Kathodenseite und einer lateral durchgehenden, n⁻-dotierten Kanalschicht (6), auf welchem Substrat ein Thyristorteil in Form eines Feldgesteuerten Thyristors (FCT) und ein Diodenteil (D) nebeneinanderliegend integriert und zueinander antiparallel geschaltet sind;

(b) im Thyristorteil (FCT) anodenseitig eine in die Kanalschicht (6) eingebrachte, p⁺-dotierte FCT-Anodenschicht (7); und kathodenseitig eine Mehrzahl von n⁺-dotierten Kathodenbereichen (3), welche durch in die Kanalschicht (6) hineinragende Gräben (12) voneinander getrennt sind, deren Böden eine tieferliegende Gateebene (14) bilden; sowie p-dotierte Gatebereiche (5), welche sich über die Böden der Gräben (12) erstrecken;

(c) im Diodenteil (D) anodenseitig eine in die Kanalschicht (6) eingebrachte n⁺-Emitterschicht (8); und kathodenseitig eine p-leitende Dioden-Anodenschicht (13), welche zusammen mit der durch den Diodenteil (D) verlaufenden Kanalschicht (6) den PN-Uebergang einer Diode bildet; dadurch gekennzeichnet, dass

(d) die Dioden-Anodenschicht (13) p⁺-dotiert ist;

(e) der im Diodenteil (D) zwischen der Dioden-Anodenschicht (13) und der Kanalschicht (6) gebildete PNUebergang oberhalb der Gateebene (14) liegt; und

(f) der Diodenteil (D) und der Feldgesteuerte Thyristor (FCT) kathodenseitig durch eine Gatezone (11) voneinander entkoppelt sind, die auf dem Boden eines bis zur Gateebene (14) hinabreichenden Grabens angeordnet ist, und deren Breite mindestens gleich der Dicke des Bauelements ist.

**2.** Rückwärtsleitender Thyristor nach Anspruch 1, dadurch gekennzeichnet, dass sich die Gatebereiche (5) auch über die Seitenwände der Gräben (12) erstrecken.

**3.** Rückwärtsleitender Thyristor nach Anspruch 2, dadurch gekennzeichnet, dass

(a) die Wände der Gräben (12) senkrecht zu deren Böden verlaufen;

(b) die Gräben (12) zwischen 10 μm und 30 μm tief sind;

(c) die Kathodenbereiche (3) zwischen 6 μm und 40 μm breit sind;

(d) die über den Gatebereichen (5) aufgebrachten Gatekontakte (2) eine zusammenhängende Kontaktschicht bilden;

(e) die Gatebereiche (5) zwischen 5 μm und 20 μm dick sind;

(f) die Gatebereiche (5) die Kathodenbereiche (3) berühren; und

(g) die Gatebereiche (5) am Rand eine Dotierungskonzentration von höchstens 2 x 10¹⁶ cm⁻³ aufweisen.

**4.** Rückwärtsleitender Thyristor nach Anspruch 1, dadurch gekennzeichnet, dass der Diodenteil (D) in der Mitte des Bauelements angeordnet ist.

**Claims**

**1.** Reverse-conducting thyristor comprising

a) a disc-shaped substrate having an anode side and a cathode side and a laterally continuous, n⁻-doped channel layer (6), on which substrate a thyristor section in the form of a field-controlled thyristor (FCT) and a diode section (D) are integrated adjacently to one another and connected in antiparallel with one another;

b) in the thyristor section (FCT) on the anode side, a p⁺-doped FCT anode layer (7) inserted into the channel layer (6); and on the cathode side, a multiplicity of n⁺-doped cathode regions (3) which are separated from one another by troughs (12) protruding into the channel layer (6), the bottoms of which form a lower-lying gate level (14); and p-doped gate regions (5) which extend over the bottoms of the troughs (12);

c) in the diode section (D), on the anode side an n⁺-type emitter layer (8) inserted into the channel layer (6); and on the cathode side, a p-type conducting diodeanode layer (13) which, together with the channel layer (6) extending through the diode section (D), forms the PN junction of a diode; characterised in that

d) the diode-anode layer (13) is p⁺-doped;

e) the PN junction formed in the diode section (D) between the diode-anode layer (13) and the channel layer (6) is located above the gate level (14); and

f) the diode section (D) and the field-controlled thyristor (FCT) are decoupled from one another on the cathode side by a gate zone (11) which is arranged at the bottom of a trough reaching down to the gate level (14), and the width of which is at least equal to the thickness of the component.

**2.** Reverse-conducting thyristor according to Claim 1, characterised in that the gate regions (5) also extend over the side walls of the troughs (12).

3. Reverse-conducting thyristor according to Claim 2, characterised in that

a) the walls of the troughs (12) extend perpendicular to their bottoms,

b) the troughs (12) have a depth of between 10 $\mu$m and 30 $\mu$m,

c) the cathode regions (3) have a width of between 6 $\mu$m and 40 $\mu$m,

d) the gate contacts (2) applied above the gate regions (5) form a coherent contact layer,

e) the gate regions (5) have a width of between 5 $\mu$m and 20 $\mu$m,

f) the gate regions (5) come into contact with the cathode regions (3) and

g) the gate regions (5) have a maximum doping concentration of 2 x $10^{16}$ cm$^{-3}$ at the edge.

4. Reverse-conducting thyristor according to Claim 1, characterised in that the diode section (D) is arranged in the centre of the component.

**Revendications**

1. Thyristor passant en inverse comprenant :

(a) un substrat en forme de disque comportant un côté d'anode et un côté de cathode ainsi qu'une couche de canal à dopage n° (6), continue latéralement, et, sur ce substrat, une partie thyristor ayant la forme d'un thyristor commandé par le champ (FCT) et une partie diode (D) sont intégrées côte a' côte et sont connectées l'une à l'autre d'une manière antiparallèle;

(b) dans la partie thyristor (FCT), du côté de l'anode, une couche d'anode de FCT à dopage p$^{+}$ (7) logée dans la couche de canal (6); et du côté de la cathode, une pluralite de domaines de cathode a dopage n$^{+}$ (3) qui sont séparés les uns des autres par des fosses (12) s'enfonçant dans la couche de canal (6), le fond de ces fosses formant un plan de gâchette (14) surbaissé; ainsi que des domaines de gâchette à dopage p (5) qui s'étendent sur les fonds des fosses (12);

(c) dans la partie diode (D), du côté de l'anode, une couche d'émetteur n$^{+}$ (8) logée dans la couche de canal (6); et du côté de la cathode, une couche d'anode de diode à conduction de type p (13) qui, conjointement avec la couche de cartel (6) s'étendant à travers la partie diode (D), forme la jonction p-n d'une diode;

caractérisé en ce que :

(d) la couche d'anode de diode (13) est à dopage p$^{+}$;

(e) la jonction p-n formée dans la partie diode (D) entre la couche d'anode de diode (13) et la couche de canal (6) est située au-dessus du plan de gâchette (14), et

(f) la partie diode (D) et le thyristor commandé par le champ (FCT) sont découplés l'un de l'autre du côté de la cathode par une zone de gâchette (11) qui est disposée sur le fond d'une fosse s'étendant jusqu'au plan de gâchette (14) et dont la largeur est au moins égale à l'épaisseur du composant.

2. Thyristor passant en inverse suivant la revendication 1, caractérisé en ce que les domaines de gâchette (5) s'étendent également sur les parois latérales des fosses (12).

3. Thyristor passant en inverse suivant la revendication 2, caractérisé en ce que :

(a) les parois des fosses (12) s'étendent perpendiculairement à leur fond;

(b) les fosses (12) ont une profondeur comprise entre 10 $\mu$m et 30 $\mu$m;

(c) les domaines de cathode (3) ont uns largeur comprise entre 6 $\mu$m et 40 $\mu$m;

(d) les contacts de gâchette (2) appliqués sur les domaines de gâchette (5) forment une couche de contact cohérente;

(e) les domaines de gâchette (5) ont une épaisseur comprise entre 5 $\mu$m et 20 $\mu$m;

(f) les domaines de gâchette (5) sont en contact avec les domaines de cathode (3), et

(g) les domaines de gâchette (5) présentent, au bord, une concentration de dopage de tout au plus 2 x $10^{16}$ cm$^{-3}$.

4. Thyristor passant en inverse suivant la revendication 1, caractérisé en ce que la partie diode (D) est installée au milieu du composant.

FIG.1A.

FIG.1B